(19) Europäisches Patentamt

European Patent Office

Office européen des brevets

(11) EP 0 817 238 B1

(12) EUROPÄISCHE PATENTSCHRIFT

(45) Veröffentlichungstag und Bekanntmachung des Hinweises auf die Patenterteilung:
25.04.2001 Patentblatt 2001/17

(51) Int Cl.7: **H01J 37/34**, C23C 14/04, F16J 10/04, F02F 1/08

(21) Anmeldenummer: 97110172.0

(22) Anmeldetag: 21.06.1997

(54) **Aluminium-Gussteil und Verfahren zu seiner Herstellung**

Aluminium cast part and method for its fabrication

Pièce moulée en aluminium et son procédé de fabrication

(84) Benannte Vertragsstaaten:
AT DE ES FR GB IE IT PT SE

(30) Priorität: 27.06.1996 DE 19625577

(43) Veröffentlichungstag der Anmeldung:
07.01.1998 Patentblatt 1998/02

(73) Patentinhaber: VAW aluminium AG
53117 Bonn (DE)

(72) Erfinder:
• Erbslöh, Hermann W., Dr.-Ing.
50733 Köln (DE)
• Feikus, Franz Josef, Dr.-Ing.
53123 Bonn (DE)
• Lugscheider, Erich, Prof. Dr.
52074 Aachen (DE)
• Löffler, Frank, Dr.-Ing.
38176 Wendeburg (DE)
• Wolff, C., Dipl.-Ing.
52062 Aachen (DE)

(74) Vertreter: Müller-Wolff, Thomas, Dipl.-Ing. et al
HARWARDT NEUMANN
Patent- und Rechtsanwälte,
Brandstrasse 10
53721 Siegburg (DE)

(56) Entgegenhaltungen:
DE-A- 4 338 768          US-A- 3 540 993
US-A- 3 974 309

• PATENT ABSTRACTS OF JAPAN vol. 014, no. 017 (C-675), 16.Januar 1990 & JP 01 259157 A (MITSUBISHI MOTORS CORP), 16.Oktober 1989,
• PATENT ABSTRACTS OF JAPAN vol. 011, no. 259 (C-441), 21.August 1987 & JP 62 060863 A (MITSUBISHI HEAVY IND. LTD), 17.März 1987,

**Beschreibung**

Die Erfindung betrifft ein Aluminium-Gußteil sowie ein Verfahren und die verwendung einer Vorrichtung zu seiner Herstellung.

Im Motorenbau werden Aluminium-Gußteile mit einer gehonten zylindrischen Innengleitfläche verwendet, die ein Rauhtiefenprofil von

$$R_k = 0,5 - 3,0 \ \mu m$$

$$R_{nk} = 0,1 - 2,0 \ \mu m$$

$$R_{vk} = 0,5 - 5,0 \ \mu m$$

gemessen nach DIN 4776 aufweist, wobei $R_k$ die Kernrauhtiefe, $R_{nk}$ die reduzierte Spitzenhöhe und $R_{vk}$ die reduzierte Riefentiefe bedeuten.

Die zylindrischen Innengleitflächen wie beispielsweise Zylinderwandungen im Ottomotor werden wegen der geringen Verschleißfestigkeit überwiegend nicht im Gußzustand eingesetzt, sondern erst nach einer Vergütung in Form einer zusätzlichen Oberflächenbehandlung.

Üblicherweise wird hierzu eine galvanische Beschichtung vorgenommen oder es wird eine übereutektische Aluminiumlegierung der sogenannte "Alusil-Werkstoff" an der Oberfläche angeätzt, so daß die siliciumhaltigen Gefügebestandteile freigelegt werden. Diese bilden dann die eigentliche Lauffläche, die im Vergleich zu Aluminiumoberfläche wesentlich verschleißfester ist.

Auf anderen Gebieten der Technik beispielsweise im Werkzeugbau sind Hartstoffschichten bekannt, wie TiN-TiAl-CN-TiCN- und CrN-Schichten, die durch ein sogenanntes PVD-Verfahren (Plasma-Vacuum-Deposition) auf ein Substrat aufgebracht werden. Derartige Schichten sind sehr hart und eignen sich infolgedessen nicht für eine Weiterbearbeitung wie sie beispielsweise bei Zylinderlaufflächen erforderlich sind.

Ein weiteres Handicap üblicher PVD-Beschichtungsverfahren besteht darin, daß die darunterliegende Grundschicht durch die Wärmeeinwirkung bei dem Schichtauftrag gleichzeitig einer ungewollten "thermischen Behandlung" unterworfen wird.

Bei höheren Temperaturen von beispielsweise über 500 °C kann der Grundwerkstoff jedoch zonal aufschmelzen oder zumindest zonal in den Erweichungsbereich gelangen, so daß die Formentreue nicht mehr gewährleistet ist.

Bei aushärtbaren Legierungen führt eine derartige Erweichung dazu, daß der Gefügezustand so wesentlich verändert wird, daß nach der Abkühlung die erforderlichen Festigkeitswerte nicht mehr erreicht werden.

Ein weiteres Problem besteht in der Haftung der aufgetragenen Schichten. Dieses Problem ist deshalb besonders wichtig, weil die aufgetragenen Schichten erheblich geringere Temperaturleitfähigkeitswerte aufweisen als die Substrate. Dies führt bei Temperaturwechselbeanspruchung dazu, daß die aufgetragene Schicht sich lösen kann.

Zur Vermeidung derartiger Nachteile wird in der WO 89/03930 (Adiabatix) vorgeschlagen, die Schicht aus thermischem Isoliermaterial mit einer Dicke von 0,002 inch auf der Zylinderoberfläche aufzutragen. Mit einer derartigen Schichtdicke soll einerseits eine ausreichende Isolierwirkung erzielt werden und andererseits die Haftfestigkeit der Schicht verbessert werden.

Aus US-A-3540993 ist eine PVD-Beschichtungsvorrichtung, bestehend aus einem Rezipienten mit Kathoden- und Anodenelementen, sowie mit Gas- und Vakuumanschlüssen bekannt.

Bei der bekannten Vorrichtung bildet der Rezipient für den Abscheidevorgang auch eine Vakuumkammer, die mit einem Rezipientendeckel verschlossen wird.

Als Anwendungsgebiete werden säure- und korrosionsbeständige Überzüge, Defusionssperren, leitende Überzüge und ähnliches genannt.

Dabei kann das Kathodenelement relativ zum Rezipienten bewegbar und die zu beschichtende Innenfläche als Rezipientenwand ausgebildet werden.

Die JP 62060863 (Patent abstracts of Japan) beschreibt ebenfalls eine Beschichtungsvorrichtung, mit einer in einem Rezipienten angebrachten Kathode. Damit soll ein mehrschichtiger Film auf ein Substrat aufgetragen werden.

Aufgabe der vorliegenden Erfindung ist es, Aluminium-Gußteile für eine zylindrische Innengleitfläche derart zu beschichten, daß eine dauerhafte, verschleißfeste und oberflächen-abbildende Schicht erzeugt wird, die eine gute Haftfestigkeit aufweist und bei der die Ausgangsrauhtiefe nahezu erhalten bleibt. Das Toleranzfeld der Oberflächenrauhigkeit vor und nach dem Beschichten soll auf + 10 % bezogen auf die maximale Rauhigkeitstiefe begrenzt werden.

Diese Aufgabe wird durch die in den Patentansprüchen angegebenen Merkmale gelöst.

Die Rauhigkeitswerte der gehonten zylindrischen Innengleitflächen von Zylinderwandungen für Ottomotoren sind deshalb von besonderer Bedeutung, weil damit die Kapazitäten der Schmiermittelreservoire definiert werden. Um die Oberfläche exakt beschreiben zu können, müssen drei Rauhigkeitswerte angegeben werden, nämlich $R_k$ die Kernrauhtiefe, $R_{nk}$ die reduzierte Spitzenhöhe und $R_{vk}$ die reduzierte Riefentiefe. Der genaue Einfluß der Schmierstofftaschenbildung kann durch einen Reibtest belegt werden. Überraschenderweise wurde festgestellt, daß die PVD-Beschichtung eine oberflächen-abbildende Eigenschaft besitzt, so daß die Honriefen ohne große Abweichungen von Ausgangswerten auch nach der Beschichtung vorliegen. Somit entfällt der für Hartstoffschichten besonders kritische Bearbeitungsfall einer spanenden Nachbearbeitung.

Die Hartstoffschichten können aus einem oder mehreren Refraktärmetallen der vierten bis sechsten Nebengruppe des Periodensystems bestehen. Es hat sich als besonders vorteilhaft erwiesen, daß die Hartstoffschicht aus den Elementen des Aluminiums und/oder Siliciums gebildet werden, da die hiermit erzielbare Schichthomogenität und Schichtdichte dem Anforderungsprofil des Motorenbaus in besonders günstiger Weise entspricht.

Sofern die Hartstoffschicht zusätzlich ein oder mehrere hartphasenbildende Elemente der Gruppe B, N, O oder C aufweist, erreicht die Abbildungsqualität der Honstruktur besonders günstige Werte. Sie weichen dann lediglich um + 0,1 μm von den Ausgangsrauhtiefen ab.

Damit an der Oberfläche der Innengleitfläche eine sehr hohe Verschleißfestigkeit erzielt wird, sollte die Hartstoffschicht einen Hartstoffanteil von mehr als 80 At-% aufweisen. Der Hartstoffanteil wird durch die Zusammensetzung der Reaktionsgase beim PVD-Verfahren gesteuert.

Sofern die Hartstoffschicht eine metallische Grundschicht aufweist, die dann bis zur Oberfläche hin einen zunehmenden Metalloidanteil enthält, läßt sich die Schichthaftung und das Schichtausbruchsverhalten von metallischen und metallkeramischen Komponenten optimieren. Als optimaler Metalloidanteil hat sich eine Hartstoffschicht von 50 At-% Metalloidanteil erwiesen.

Weitere Gesichtspunkte wie beispielsweise die Ausbildung einer Einlaufschicht oder die Spannungsminimierung im Schichtverbund lassen sich durch den Schichtaufbau mit Gradientenstruktur verwirklichen. Hierbei ist eine metallische Grundschicht mit einem Metallanteil von < 90 At.-% als Haftschicht auf dem Aluminium-Gußteil aufgetragen und der darüberliegende Hartstoffanteil nimmt bis zur Oberfläche der Innengleitfläche bis auf 100 At.-% zu.

Sofern in der Grundschicht eine Titan-Aluminium-Carbonitridlegierung vorliegt und in den darüberliegenden Aufbauschichten der Anteil des Metalloids aus Kohlenstoff und Stickstoff auf bis zu 50 At.-% zunimmt, ist eine optimale Dämpfungsfunktion des Zwischenschichtmaterials erreicht, die auch eine gewisse Duktilität für auftretende Spannungen aufweist. Eine optimierte Legierung für das als Substrat eingesetzte Aluminium-Gußteil weist folgende Zusammensetzung auf:

| Silizium | 5 bis 13 Gew.-% |
|---|---|
| Eisen | 0,3 bis 1,4 Gew.-% |
| Kupfer | < 3,5 Gew.-% |
| Magnesium | < 0,5 Gew.-% |
| Mangan | < 0,5 Gew.-% |
| Restaluminium und herstellungsbedingte Verunreinigungen. | |

Hierbei ist zu berücksichtigen, daß auf dem relativ weichen Aluminium-Grundwerkstoff eine harte Verschleißschutzschicht aufgebracht worden ist und die Zwischenschicht somit das Auftreten von eventuellen Ermüdungsrissen verhindern muß. Im vorliegenden Fall wird die Zwischenschicht durch Zugabe von Härtebildnern in einen inneren Spannungszustand versetzt, so daß durch innere Spannungen gezielt Eigenspannungen induziert werden können. Im Gegensatz zu einer Mehrlagenschicht, bei denen sich die Eigenschaften von Schicht zu Schicht stufenweise ändern, wird mit der Gradientenschicht ein nahezu nahtloser Übergang und damit eine kontinuierliche Anpassung an die jeweils herrschenden Spannungsverhältnisse erzeugt. In diesem Zusammenhang hat sich das Verhältnis von Metall/Metalloid als besonders wichtig erwiesen. Unter dem Begriff "Hartstoffschicht" soll daher eine Metall/Metalloid-Verbindung verstanden werden, deren Zusammensetzung stufenlos über den Reaktivgasanteil veränderbar ist und von reinmetallisch bis auf ein vorgegebenes Metall/Metalloid-Verhältnis veränderbar ist. Im Anwendungsfall des Aluminium-Motorblocks sind oft mehrere zylindrische Gleitflächen mit einem Durchmesser von 30 bis 150 mm in Reihe angeordnet. Hierbei wird als besonderer Vorteil der vorliegenden Erfindung angesehen, daß der Abstand zwischen den jeweils benachbarten Gleitflächen auf 2 - 8 mm herabgesetzt werden kann.

Die Dicke der Schicht über die Länge der Innengleitfläche in Gleitrichtung gesehen variiert innerhalb eines engen Bereiches von ± 10 %. Der gleiche Toleranzbereich gilt für die Dicke der Schicht über den Umfang gesehen. Dieses ist bei den erwähnten dünnen Schichten mit einem Gesamtschichtaufbau von 0,5 - 20 μm ein erstaunlich niedriger Toleranzbereich, der nur durch das nachfolgend beschriebene PVD-Beschichtungsverfahren gemäß der vorliegenden Erfindung erreicht werden kann.

Das erfindungsgemäße Beschichtungsverfahren läuft mehrstufig ab und zwar wird zunächst in einem Ionen-Ätzverfahren die Oberfläche gereinigt und unmittelbar danach im gleichen Bearbeitungsraum auf die gereinigte Oberflächenstruktur eine Hartstoffschicht bei Temperaturen unterhalb von 250 °C aus der Gasphase abgeschieden. Mit dem als oberflächen-abbildenden Beschichtungsverfahren eingesetzten PVD (Plasma-Vacuum-Deposition)-Verfahren kann das Rauhtiefenprofil der Ursprungs-Oberfläche innerhalb einer engen Toleranzbreite von ± 10 % nachgebildet werden.

Es sind sowohl Multilayer-Schichten als auch eine Schicht mit Gradientenstruktur durch eine unterschiedliche Zusammensetzung des Reaktivgasanteiles erzielbar. Bei besonders dünnen Haftschichten sind eine Grundschicht von TiAl mit der Zusammensetzung 50/50 und Deckschichten von CrAl oder SiC vorteilhaft.

Eine Vorrichtung zur Aufbringung der PVD-Beschichtung besteht darin, daß das Kathodenelement als Stabkathode ausgebildet ist, wobei die Stabkathode in einen Rezipientendeckel in Stablängsrichtung beweglich angeordnet ist.

Der Rezipientenboden ist mit Gas- und Vakuumanschlüssen gegenüber den Stabkathoden versehen, wobei die zu beschichtenden Innengleitflächen als Rezipientenwände ausgebildet sind und wobei der Rezipientendeckel und der Rezipientenboden mit den Rezipientenwänden vakuumdicht verschließbar ist.

Grundsätzlich sind verschiedene Abdichtungssysteme verwendbar. Eine besonders einfache und doch sehr effektive Abdichtung besteht darin, daß die Dichtflächen am Rezipienten und am Deckel mechanisch bearbeitet sind. Eine andere Abdichtungsmöglichkeit besteht in der Verwendung besonderer Dichtungsteile aus temperaturbeständigen Materialien. Hierbei kann auf bekannte Materialien zurückgegriffen werden.

Als besonders verschleißfest haben sich die Schichtsysteme mit den ternären Legierungen Ti-Al-N und Cr-Al-N erwiesen. Die Chrom-Basisschichten können dabei auch als Korrosionsschutzschichten eingesetzt werden. Die Ti-Al-N-Schichten sind als Deckschichten wegen ihrer besonderen Härte vorgesehen.

Im folgenden wird ein Beispiel für das erfindungsgemäße Verfahren angegeben:

Nach dem Evakuieren auf einen Druck von X wird das Gas auf eine Temperatur von 200 - 250 °C aufgeheizt. Dann folgt ein Reinigungsvorgang durch Ätzen und unmittelbar danach die Zuführung der heißen Prozeßgase.

Nach dem Abkühlen wird der Rezipient geflutet und der Substratträger entnommen.

Typische Druckverhältnisse beim PVD-Verfahren liegen zwischen $10^{-4}$ und $10^{-6}$ mbar, das Fluten erfolgt mit Argon mit $10^{-1}$ bis $10^{-4}$ mbar.

Aufgrund der hohen negativen Spannung, die beim Anlegen der Potentialdifferenz entstehen, werden die Erdgasteilchen, die sich zwischen Target und Substrat befinden, ionisiert. Dabei entsteht ein hochenergetisches Plasma, in dem die positiv geladenen Erdgasionen mit einer Energie von einigen keV gegen die negativ geladene Targetoberfläche fliegen. Durch Stoßprozesse erfolgt eine Impuls- und Energieübertragung und schließlich das Herauslösen von Atomen aus dem beschossenen Targetmaterial, das dann ohne Zwischenschaltung einer flüssigen Phase aus dem festen Aggregatzustand in die Gasphase übergeht.

Die herausgeschlagenen Teilchen werden durch Anlegung der Spannung auf dem Substrat niedergeschlagen und wachsen dort zu einer homogenen Schicht auf.

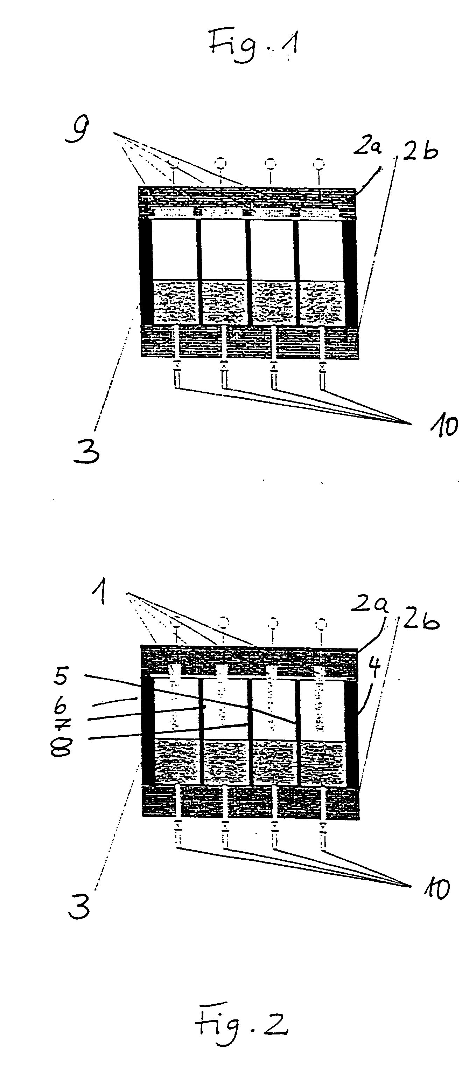

Bei Anwendung dieses Beschichtungsverfahrens auf die Herstellung von zylindrischen Innengleitflächen von Motorenblöcken kann eine Beschichtungsanlage, wie in Figur 1 und 2 dargestellt, verwendet werden.

In Figur 1 sind die Zylinderwände eines Vierzylinder-Motors im Längsquerschnitt dargestellt. Sie dienen als Rezipientenwände 4 - 8, die oben und unten mit einem Rezipientendeckel 2a, 2b verschlossen sind. An den Deckeln und an den entsprechenden Gegenflächen des Rezipienten sind Dichtflächen angeordnet, wodurch sich zwischen den Deckeln und den Rezipientenwänden eine oder mehrere Vakuumkammern bilden.

Im oberen Rezipientendeckel 2a befinden sich ebene Kathoden 9 und im unteren Rezipientendeckel 2b die Gas- und Vakuumanschlüsse 10. Somit ist der Motorblock, z. B. ein Aluminium-Gußteil, gleichzeitig der Rezipient für den Abscheidevorgang. Das Kathodenelement kann auch relativ zum Rezipienten bewegbar und einfahrbar angeordnet werden.

In Figur 2 ist analog zu Figur 1 der Zylinderblock 3 im Längsquerschnitt mit äußeren Zylinderwänden 4 und 6 sowie inneren Zylinderwänden 5, 7 und 8 dargestellt. Im Unterschied zur Figur 1 sind hier keine ebenen Kathoden sondern Stabkathoden 1 beweglich im Rezipientendeckel 2a angeordnet.

Vor Inbetriebnahme der Beschichtungsanlage wird zunächst der Zylinderraum 13 evakuiert. Nach dem Anschluß der Rezipientendec kel 2a, 2b wird der Ätzprozeß zur Reinigung der Oberfläche gestartet. Unmittelbar daran anschließend läuft der Beschichtungsprozeß ab. Eine Multilayer-Schicht oder Schicht mit Gradientenstruktur wird durch eine Veränderung der Zusammensetzung der Reaktionsgase erzeugt.

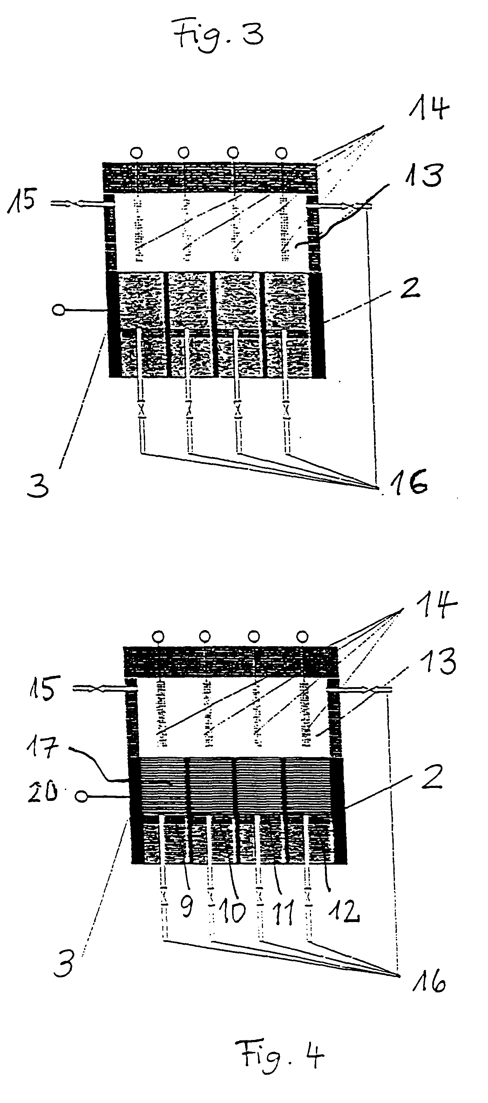

Weitere Einzelheiten des Beschichtungsverfahrens werden anhand der Figuren 3 bis 6 erläutert. Sie zeigen jeweils Längsquerschnitte durch den Zylinderblock 3 bei den folgenden Verfahrensstufen:

1. Evakuieren siehe Figur 3

Über die Gas- und Vakuumanschlüsse 15, 16 wird ein Vakuum im Zylinderinnenraum 13 angelegt. Die Stabkathoden 14 befinden sich in Ruheposition.

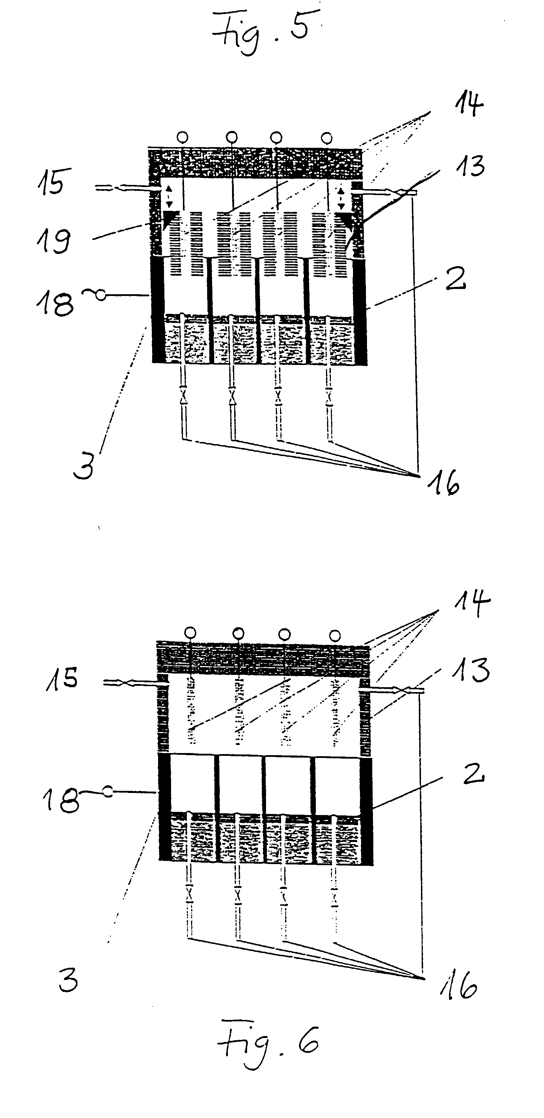

2. Plasmareinigen gemäß Figur 4

Die Zylinderwände werden über den Stromanschluß 20 als Kathode geschaltet und dadurch die Verunreinigungen über die Gas- und Vakuumanschlüsse 15, 16 abgesaugt. Das Plasma 17 ist schematisch durch Schraffur in den Zylinderinnenräumen angedeutet.

3. Beschichten gemäß Figur 5

Nach einer Umpolung wird die Stabkathode 14 abgesenkt und wirkt nun als Target für die als Anode 18 geschalteten Zylinderwände. Das Vakuum wird über die Gas- und Vakuumanschlüsse 15, 16 aufrechterhalten. Mit 19 ist die Verfahreinrichtung für die Stabkathoden 14 angedeutet, mit 17 das Plasma zwischen den Stabkathoden und den Zylinderwänden.

4. Kühlen gemäß Figur 6

Nach Beendigung des Beschichtungsvorganges wird die Stromversorgung für die Plasmabeschichtung abgeschaltet und die Stabkathoden 14 werden aus der Beschichtungsposition im Innern der Zylinder herausgefahren. Über die Gas- und Vakuumanschlüsse 15, 16 können Kühlgase zugeführt werden.

Der Ablauf des erfindungsgemäßen Verfahrens wurde schematisch anhand der beiliegenden Figuren erläutert, die Seitenansichten des prinzipiellen Aufbaus der erfindungsgemäßen Vorrichtung zeigen. Bei anderen Anwendungsfällen kann die Vorrichtung nach dem Prinzip des kleinsten Beschichtungsraumes leicht abgewandelt werden.

Als Substratwerkstoff wurde in dem vorgeschriebenen Verfahren die Legierung AlSi9Cu3 im ausgehärteten Zustand eingesetzt. Der Substratwerkstoff hatte dabei die folgende Wärmebehandlung erfahren: Lösungsglühen, Abschrecken und Warmauslagern.

Es ergaben sich die in der nachfolgenden Tabelle angegebenen Schichtdicken, die mit dem Kalotten-Schleiftest gemessen wurden. Die besonders gleichmäßige Schichtdicke konnte dadurch erreicht werden, daß das Kathoden-Element als Stabkathode ausgebildet ist und in dem Rezipientendeckel in Stablängsrichtung während des Beschichtungsvorganges an der Zylinderlängsachse entlang verfahren wird.

Für die Hochleistungskathodenzerstäubung kann ein Permanentmagnet oberhalb des Targets angeordnet sein, der für ein Magnetfeld sorgt, dessen Magnetfeldlinien die Targetebenen senkrecht durchsetzen. Durch das Zusammenwirken von elektrischem und magnetischem Feld werden die Elektronen im Plasma aufgrund der Lorenzkraft auf verlängerte spiralförmige Bahnen gelenkt.

Durch diese Maßnahme verringert sich die effektive Weglänge der Elektronen, so daß die Ionisationswahrscheinlichkeit und damit die Anzahl der Inerdgasionen steigt. Die Aufwachsbedingungen der Schichten werden durch eine Beheizung des Substrats während des Beschichtungsvorganges verbessert.

Zusammenfassend läßt sich feststellen, daß durch die erfindungsgemäße Vorrichtung ermöglicht wird, die Zylinderwand als Teil der Rezipientenkonstruktion zu nutzen. Dadurch ergeben sich besonders kleine Vakuumräume, die leichter abdichtbar sind. Ferner ist die zu reinigende Fläche der Motorblöcke auf die ausschließlich zu beschichtende Flächen beschränkt. Somit sind nur die den Rezipienten bildenden Zylinderwände vom Vakuum beaufschlagt und auch dort nur werden die Beschichtungsvorgänge ablaufen, so daß auf eine unnötige Reinigung von nicht zu beschichtenden Teilen verzichtet werden kann.

## Patentansprüche

1. Aluminium-Gußteil mit einer gehonten, zylindrischen Innengleitfläche, die ein Rauhtiefenprofil von

$$R_k = 0,5 - 3,0 \; \mu m$$

$$R_{nk} = 0,1 - 2,0 \; \mu m$$

$$R_{vk} = 0,5 - 5,0 \; \mu m$$

gemessen nach DIN 4776 aufweist, wobei $R_k$ die Kernrauhtiefe, $R_{nk}$ die reduzierte Spitzenhöhe und $R_{vk}$ die re-

duzierte Riefentiefe bedeuten,
dadurch gekennzeichnet,
daß die Innengleitfläche des Aluminium-Gußteils eine aus der Gasphase abgeschiedene Hartstoffschicht trägt und die mit dem Hartstoff beschichtete Aluminium-Gußteiloberfläche ein Rauhtiefenprofil von

$$R_k = 0,5 - 2,8 \ \mu m$$

$$R_{nk} = 0,1 - 1,8 \ \mu m$$

$$R_{vk} = 0,5 - 4,8 \ \mu m$$

aufweist.

2. Aluminium-Gußteil nach Anspruch 1,
dadurch gekennzeichnet,
daß die Hartstoffschicht aus einem oder mehreren Refraktärmetallen der vierten bis sechsten Nebengruppe des Periodensystems besteht.

3. Aluminium-Gußteil nach Anspruch 1 oder 2,
dadurch gekennzeichnet,
daß die Hartstoffschicht aus den Elementen Aluminium und/oder Silizium gebildet wird.

4. Aluminium-Gußteil nach Anspruch 1, 2 oder 3,
dadurch gekennzeichnet,
daß die Hartstoffschicht zusätzlich ein oder mehrere hartphasenbildende Elemente der Gruppe B, N, O und/oder C aufweist.

5. Aluminium-Gußteil nach einem der vorhergehenden Ansprüche,
dadurch gekennzeichnet,
daß die Hartstoffschicht einen Hartstoffanteil an der Oberfläche von mehr als 80 At. % aufweist.

6. Aluminium-Gußteil nach einem der vorhergehenden Ansprüche,
dadurch gekennzeichnet,
daß der Anteil der Metallatome in der Hartstoffschicht größer als 30 At. % ist.

7. Aluminium-Gußteil nach einem der vorhergehenden Ansprüche,
dadurch gekennzeichnet,
daß der Metalloidanteil innerhalb der Hartstoffschicht bis auf 50 At. % ansteigt.

8. Aluminium-Gußteil nach einem der vorhergehenden Ansprüche,
dadurch gekennzeichnet,
daß die Gußteiloberfläche einen mehrlagigen Schichtaufbau mit einer Gesamtschichtdicke von 0,5 - 20 μm aufweist.

9. Aluminium-Gußteil nach einem der vorhergehenden Ansprüche,
dadurch gekennzeichnet,
daß die Hartstoffschicht eine metallische Grundschicht und einen bis zur Oberfläche hin zunehmenden Metalloidanteil aufweist.

10. Aluminium-Gußteil nach einem der vorhergehenden Ansprüche,
dadurch gekennzeichnet,
daß in der Grundschicht eine Titan-Aluminium-Carbonitrid-Legierung vorliegt und in den darüberliegenden Aufbauschichten der Anteil des Metalloids aus Kohlenstoff und Stickstoff auf bis zu 50 At. % zunimmt.

11. Aluminium-Gußteil nach einem der vorhergehenden Ansprüche,

dadurch gekennzeichnet,

daß der Schichtaufbau eine Gradientenstruktur zeigt, wobei eine metallische Grundschicht mit einem Metallanteil größer als 90 At. % als Haftschicht auf einem Aluminiumgußteil ausgebildet ist und in der oder den darüberliegenden Aufbauschichten der Hartstoffanteil bis auf 100 At. % zunimmt.

12. Aluminium-Gußteil nach einem der vorhergehenden Ansprüche,
dadurch gekennzeichnet,
daß die Legierungszusammensetzung des Aluminium-Gußteils folgende Legierungselemente aufweist:

| Silizium | 5 bis 13 Gew.-% |
|---|---|
| Eisen | 0,3 bis 1,4 Gew.-% |
| Kupfer | < 3,5 Gew.-% |
| Magnesium | < 0,5 Gew.-% |
| Mangan | < 0,5 Gew.-% |
| Rest Aluminium und herstellungsbedingte Verunreinigungen | |

und daß in die Zusammensetzung der Hartstoffschicht nitridund/oder carbidbildende Refraktärmetalle aus den Elementen der vierten bis sechsten Nebengruppe des Periodensystems eingelagert sind.

13. Aluminium-Gußteil nach einem der vorhergehenden Ansprüche,
dadurch gekennzeichnet,
daß in einem Aluminium-Motorblock eine oder mehrere zylindrische Gleitflächen mit einem Innendurchmesser von 30 - 150 mm in einem Abstand von 2 - 8 mm nebeneinander angeordnet sind.

14. Aluminium-Gußteil nach einem der vorhergehenden Ansprüche,
dadurch gekennzeichnet,
daß die Dicke der Schicht über die Länge der Innengleitfläche in Gleitrichtung gesehen in einem Bereich von ± 10 % variiert und daß die Dicke der Schicht über den Umfang gesehen einen Toleranz-Bereich von ± 10 % aufweist.

15. Verfahren zur Herstellung von Aluminium-Gußteilen mit gehonten zylindrischen Innengleitflächen nach einem der vorhergehenden Ansprüche, wobei zunächst die Oberfläche des Aluminium-Gußteils gereinigt und dann eine Hartstoffschicht aufgebracht wird,
dadurch gekennzeichnet,
daß die Oberfläche des Aluminium-Gußteiles an der zu beschichtenden Fläche mit einem Rauhtiefenprofil im Bereich von

$$R_k = 0,5 - 3,0 \ \mu m$$

$$R_{nk} = 1,0 - 2,0 \ \mu m$$

$$R_{vk} = 0,5 - 5,0 \ \mu m$$

gemessen nach DIN 4776 durch ein Ionen-Ätzverfahren gereinigt und unmittelbar danach auf die erhaltene Oberflächenstruktur eine Hartstoffschicht mit einem oberflächen-abbildenden Beschichtungsverfahren bei Temperaturen unterhalb von 250 °C aus der Gasphase abgeschieden wird, wobei eine Oberflächenschicht mit einem Hartstoffanteil von mehr als 80 At. % gebildet wird.

16. Verfahren nach dem vorhergehenden Anspruch,
dadurch gekennzeichnet,
daß als oberflächen-abbildendes Beschichtungsverfahren ein PVD- (Plasma-Vacuum-Deposition)-Verfahren angewendet wird und die beschichtete Oberfläche ein Rauhtiefenprofil von

$$R_k = 0,5 - 2,8 \ \mu m$$

$$R_{nk} = 0,1 - 1,8 \ \mu m$$

$$R_{vk} = 0,5 - 4,8 \ \mu m \ aufweist.$$

**17.** Verfahren nach einem der vorhergehenden Ansprüche,
dadurch gekennzeichnet,
daß eine Multilayer-Schicht abgeschieden wird, wobei auf dem Substratwerkstoff erst eine metallische Haftschicht aus TiAl mit der Zusammensetzung (50/50) aufgedampft wird und darauf eine Deckschicht aus einem Metalloid abgeschieden wird.

**18.** Verfahren nach einem der vorhergehenden Ansprüche,
dadurch gekennzeichnet,
daß die Zusammensetzung der Haftschicht über die Reaktivgasanteil gesteuert wird.

**19.** Verfahren nach einem der vorhergehenden Ansprüche,
dadurch gekennzeichnet,
daß die Haftschicht aus TiAl mit der Zusammensetzung (50/50) besteht und die Deckschicht aus Ti, Si, Al und/oder Cr mit einem Hartphasen-(Metalloid)-bildenden Gas aus der Gruppe B, C, N, O bei Temperaturen von 150 - 250°C zur Reaktion gebracht und auf der Haftschicht abgeschieden werden.

**20.** Verfahren nach einem der vorhergehenden Ansprüche,
dadurch gekennzeichnet,

daß der Rezipientendeckel in Form eines Zylinderkopfdeckels auf die Rezipientenwände aufgelegt und angepreßt wird und

daß die Zusammensetzung der Haftschicht und der Deckschicht über die Reaktivgasanteile gesteuert wird.

**21.** Verfahren nach einem der vorhergehenden Ansprüche,
dadurch gekennzeichnet,
daß der Rezipientendeckel nur auf die den äußeren Umfang bildenden Rezipientenwände (4 und 6) aufgelegt wird.

**22.** Verwendung einer Vorrichtung zur PVD-Beschichtung, bestehend aus einem Rezipienten mit Kathoden- und Anodenelementen sowie von Gas- und Vakuumanschlüssen, wobei das Kathodenelement relativ zum Rezipienten bewegbar und einfahrbar angeordnet ist, für eine PVD-Beschichtung einer zylindrischen Innengleitfläche von Aluminium-Gußteilen (3), wobei das Aluminium-Gußteil (3) der Rezipient für den Abscheidevorgang ist.

**23.** Verwendung einer Vorrichtung nach Anspruch 22,
dadurch gekennzeichnet,

daß das Kathodenelement als Stabkathode (1) ausgebildet ist, die in einem Rezipientendeckel (2a) in Stablängsrichtung beweglich angeordnet ist,

daß ein Rezipientenboden (2b) mit Gas- und Vakuumanschlüssen gegenüber den Stabkathoden (1) angeordnet ist,

und daß die zu beschichtenden Innengleitflächen als Rezipientenwände (4-8) ausgebildet sind, wobei der Rezipientendeckel (2a) und der Rezipientenboden (2b) mit den Rezipientenwänden vakuumdicht verschließbar sind.

**24.** Verwendung einer Vorrichtung nach einem der Ansprüche 22 oder 23,
dadurch gekennzeichnet,
daß als Verschlußelemente Verschlußplatten mit Dichtflächen an entsprechenden Gegenflächen eines oder mehrerer Rezipienten angelegt sind, wodurch sich eine oder mehrere Vakuumkammern bilden.

**25.** Verwendung einer Vorrichtung nach einem der Ansprüche 22, 23, 24,

dadurch gekennzeichnet,
daß der Rezipientenboden (2a) aus mehreren Einzelflächen (9-12) gebildet ist, die in jeweils ein zylindrisches Aluminium-Gußteil (3) einführbar und gegen die Innengleitflächen vakuumdicht anpreßbar sind.

**26.** Verwendung einer Vorrichtung nach einem der Ansprüche 22 bis 25,
dadurch gekennzeichnet,
daß die Gegenfläche des Rezipienten als mechanisch bearbeitete Dichtfläche ausgebildet ist.

**27.** Verwendung einer Vorrichtung nach einem der Ansprüche 22 bis 26,
dadurch gekennzeichnet,
daß ein Dichtungsteil aus einem temperaturbeständigen Material eingesetzt wird.

**28.** Verwendung einer Vorrichtung nach einem der Ansprüche 22 bis 27,
dadurch gekennzeichnet,
daß zum Aufsetzen der Verschlußplatten sowie zum Verschließen der Vakuumkammern eine oder mehrere Verspanneinrichtungen vorgesehen sind.

**Claims**

**1.** An aluminium casting having a honed cylindrical inner sliding face which comprises a peak-to-valley height profile of

$$R_k = 0.5 - 3.0 \ \mu m$$

$$R_{nk} = 0.1 - 2.0 \ \mu m$$

$$R_{vk} = 0.5 - 5.0 \ \mu m$$

measured in accorcance with DIN 4776, wherein $R_k$ refers to the peak-to-valley height of the core, $R_{nk}$ to the reduced peak height and $R_{vk}$ to the reduced scoring depth,
characterised in
that the inner sliding face of the aluminium casting carries a layer of hard material separated from the gas phase and that the surface of the aluminium casting coated with the hard material comprises a peak-to-valley height profile of

$$R_k = 0.5 - 2.8 \ \mu m$$

$$R_{nk} = 0.1 - 1.8 \ \mu m$$

$$R_{vk} = 0.5 - 4.8 \ \mu m$$

**2.** An aluminium casting according to claim 1,
characterised in
that the layer of hard material consists of one or several refractory metals of the fourth to sixth subsidiary groups of the periodic system.

**3.** An aluminium casting according to claim 1 or 2,
characterised in
that the layer of hard material is formed of the elements of aluminium and/or silicon.

**4.** An aluminium casting according to claims 1, 2 or 3,
characterised in

that the layer of hard material additionally comprises one or several hard-phase forming elements of group B, N, O and or C.

5. An aluminium casting according to any one of the preceding claims, characterised in that the layer of hard material, on its surface, comprises a hard material percentage in excess of 80 atom. %.

6. An aluminium casting according to any one of the preceding claims, characterised in that the percentage of metal atoms in the layer of hard material is greater than 30 atom. %.

7. An aluminium casting according to any one of the preceding claims, characterised in that the percentage of metalloid inside the layer of hard material increases up to 50 atom. %.

8. An aluminium casting according to any one of the preceding claims, characterised in that the casting surface comprises a multi-layer structure with a total layer thickness of 0.5 - 20 $\mu$m.

9. An aluminium casting according to any one of the preceding claims, characterised in that the layer of hard material comprises a metallic basic layer and a percentage of metalloid which increases as far as the surface.

10. An aluminium casting according to any one of the preceding claims, characterised in that in the basic layer there is present a titanium carbo-nitride alloy and that in the structural layers thereabove, the percentage of metalloids of carbon and nitrogen increases up to 50 atom. %.

11. An aluminium casting according to any one of the preceding claims, characterised in that the layer structure comprises a gradient and that there is formed a metallic basic layer with a percentage of metal in excess of 90 atom. % in the form of an adherence layer on an aluminium casting and that in the structural layer(s) thereabove, the percentage of hard material increases up to 100 atom. %.

12. An aluminium casting according to any one of the preceding claims, characterised in that the alloy composition of the aluminium casting comprises the following alloy elements:

| silicon | 5 to 13 % by weight |
|---|---|
| iron | 0.3 to 1.4 % by weight |
| copper | < 3.5 % by weight |
| magnesium | < 0.5 % by weight |
| manganese | < 0.5 % by weight |
| the residual elements being aluminium and production-related impurities | |

and that in the composition of the layer of hard material, there are included nitride- and/or carbideforming refractory metals of the elements of the fourth to sixth subsidiary groups of the periodic system.

13. An aluminium casting according to any one of the preceding claims, characterised in that in an aluminium engine block, there are arranged, side by side, one or several cylindrical sliding faces with an internal diameter of 30 - 150 mm at a distance of 2 - 8 mm.

14. An aluminium casting according to any one of the preceding claims, characterised in that the thickness of the layer, if viewed along the length of the inner sliding face in the direction of sliding, varies within a range of $\pm$ 10 % and that the thickness of the layer, if viewed across the circumference, comprises a tolerance range of $\pm$ 10 %.

**15.** A method of producing aluminium castings with honed cylindrical inner sliding faces according to any one of the preceding claims, wherein first the surface of the aluminium casting is cleaned and wherein, subsequently, a layer of hard material is applied,
characterised in
that the region of the aluminium casting surface which has to be coated and comprises a peak-to-valley profile in the range of

$$R_k = 0.5 - 3.0 \ \mu m$$

$$R_{nk} = 0.1 - 2.0 \ \mu m$$

$$R_{vk} = 0.5 - 5.0 \ \mu m$$

measured in accordance with DIN 4776 is cleaned by an ion etching method and that immediately thereafter, a layer of hard material is separated from the gas phase on to the obtained surface structure by means of a surface copying coating method at temperatures below 250 °C, wherein there is formed a surface layer with a hard material percentage in excess of 80 atom. %.

**16.** A method according to the preceding claims,
characterised in
that as a surface copying coating method, there is used a PVD (plasma vacuum deposition) method and that the coated surface comprises a peak-to-valley height profile of

$$R_k = 0.5 - 2.8 \ \mu m$$

$$R_{nk} = 0.1 - 1.8 \ \mu m$$

$$R_{vk} = 0.5 - 4.8 \ \mu m.$$

**17.** A method according to any one of the preceding claims,
characterised in
that there is separated a multi-layer coating and that on to the substrate material, there is first steamed on a metallic adherence layer of TiAl with the composition of (50/50) on to which a cover layer consisting of metalloid is separated.

**18.** A method according to any one of the preceding claims,
characterised in
that the composition of the adherence layer is controlled via the percentage of reactive gas.

**19.** A method according to any one of the preceding claims,
characterised in
that the adherence layer consists of TiAl with the composition of (50/50) and that the cover layer of Ti, Si, Al and/ or Cr is made to react by means of a gas forming hard phases (metalloid), of group B, C, N, O at temperatures of 150 - 250 °C, and separated on to the adherence layer.

**20.** A method according to any one of the preceding claims,
characterised in
that the recipient cover in the form of a cylinder block cover is placed on to, and pressed against, the recipient walls and that the composition of the adherence layer and of the cover layer is controlled via the percentages of reactive gas.

**21.** A method according to any one of the preceding claims,
characterised in
that the recipient cover is placed only on to the receiving walls (4 and 6) forming the outer circumference.

**22.** The use of a device for PVD coating, consisting of a recipient with cathode and anode elements as well as gas and vacuum connections, wherein the cathode element is arranged so as to be displaceable relative to, and movable into, the recipient, said device being provided for the purpose of PVD coating a cylindrical inner sliding face of an aluminium casting (3), with the aluminium casting (3) being the recipient for the separating process.

**23.** The use of a device according to claim 22,
characterised in
that the cathode element is provided in the form of a bar electrode (1) which is arranged in a recipient cover (2a) so as to be movable in the longitudinal direction of the bar; the recipient base (2b) with gas and vacuum connections is arranged opposite the bar cathodes (1); and that the inner sliding faces to be coated are provided in the form of recipient walls (4-8) and that the recipient cover (2a) and the recipient base (2b) are sealable relative to the recipient walls so as to be vacuum-proof.

**24.** The use of a device according to any one of claims 22 or 23,
characterised in
that the sealing elements are provided in the form of sealing plates with sealing faces at corresponding counter faces of one or several recipients, as a result of which one or several vacuum chambers are formed.

**25.** The use of a device according to any one of claims 22, 23, 24,
characterised in
that the recipient base (2a) is formed of several individual faces (9 - 12) which each can be introduced into a cylindrical aluminium casting (3) and can be pressed against the inner sliding faces so as to be vacuum-proof.

**26.** The use of a device according to any one of claims 22 to 25,
characterised in
that the counter face of the recipient is provided in the form of a machined sealing face.

**27.** The use of a device according to any one of claims 22 to 26,
characterised in
that there is inserted a sealing part consisting of a temperature-resistant material.

**28.** The use of a device according to any one of claims 22 to 27,
characterised in
that for the purpose of positioning the sealing plates and for sealing the vacuum chambers, there are provided one or several clamping devices.


**Revendications**

**1.** Pièce de fonderie en aluminium à surface de coulissement intérieure cylindrique rodée, présentant un profil de profondeur de rugosité de :

$$R_k = 0,5 - 3,0 \ \mu m$$

$$R_{nk} = 0,1 - 2,0 \ \mu m$$

$$R_{vk} = 0,5 - 5,0 \ \mu m$$

mesuré selon la norme DIN 4776, $R_k$ étant la profondeur de rugosité à coeur, $R_{nk}$ étant la hauteur de pointes réduite et $R_{vk}$ étant la profondeur de creux réduite,
caractérisée en ce que la surface de coulissement intérieure de la pièce de fonderie en aluminium porte une couche en substance dure déposée à partir d'une phase gazeuse, et en ce que la surface revêtue de la substance dure de la pièce de fonderie en aluminium présente un profil de profondeur de rugosité de :

$$R_k = 0,5 - 2,8 \ \mu m$$

$$R_{nk} = 0,1 - 1,8 \ \mu m$$

$$R_{vk} = 0,5 - 4,8 \ \mu m$$

**2.** Pièce de fonderie en aluminium selon la revendication 1, caractérisée en ce que la couche en substance dure est constituée en un ou plusieurs métaux réfractaires du quatrième au sixième sous-groupe de la classification périodique.

**3.** Pièce de fonderie en aluminium selon l'une ou l'autre des revendications 1 et 2, caractérisée en ce que la couche en substance dure est formée à partir des éléments que sont l'aluminium et/ou le silicium.

**4.** Pièce de fonderie en aluminium selon l'une quelconque des revendications 1, 2 et 3, caractérisée en ce que la couche en substance dure comprend en supplément un ou plusieurs éléments formant une phase dure parmi le groupe B, N, O et/ou C.

**5.** Pièce de fonderie en aluminium selon l'une quelconque des revendications précédentes, caractérisée en ce que la couche en substance dure comprend à la surface une proportion de substance dure supérieure à 80 atomes %.

**6.** Pièce de fonderie en aluminium selon l'une quelconque des revendications précédentes, caractérisée en ce que la proportion des atomes métalliques dans la couche en substance dure est supérieure à 30 atomes %.

**7.** Pièce de fonderie en aluminium selon l'une quelconque des revendications précédentes, caractérisée en ce que la proportion de métalloïdes au sein de la couche en substance dure s'élève jusqu'à 50 atomes %.

**8.** Pièce de fonderie en aluminium selon l'une quelconque des revendications précédentes, caractérisée en ce que la surface de la pièce de fonderie présente une structure à plusieurs couches d'une épaisseur totale de 0,5 à 20 µm.

**9.** Pièce de fonderie en aluminium selon l'une quelconque des revendications précédentes, caractérisée en ce que la couche en substance dure comprend une couche de base métallique et une proportion de métalloïde qui augmente jusqu'à la surface.

**10.** Pièce de fonderie en aluminium selon l'une quelconque des revendications précédentes, caractérisée en ce que la couche de base comprend un alliage de titane/aluminium/nitrure de carbone, et en ce que dans les couches de structure situées au-dessus la proportion du métalloïde en carbone et azote s'élève jusqu'à 50 atomes %.

**11.** Pièce de fonderie en aluminium selon l'une quelconque des revendications précédentes, caractérisée en ce que l'empilement de couches présente une structure à gradient, en ce qu'une couche de base métallique avec une proportion de métal supérieure à 90 atomes % est réalisée en tant que couche adhésive sur une pièce de fonderie en aluminium, et en ce que la proportion de substance dure dans la ou les couches situées au-dessus augmente jusqu'à 100 atomes %.

**12.** Pièce de fonderie en aluminium selon l'une quelconque des revendications précédentes, caractérisée en ce que la composition d'alliage de la pièce de fonderie en aluminium comprend les éléments d'alliage suivants :

| silicium | 5 à 13 % en poids |
|---|---|
| fer | 0,3 à 1,4 % en poids |
| cuivre | < 3,5 % en poids |
| magnésium | < 0,5 % en poids |
| manganèse | < 0,5 % en poids |

(suite)

le reste étant de l'aluminium et des impuretés dues à la fabrication,

et en ce que dans la composition de la couche en substance dure sont inclus des métaux réfractaires formant des nitrures et/ou des carbures choisis parmi les éléments du quatrième au sixième sous-groupe de la classification périodique.

**13.** Pièce de fonderie en aluminium selon l'une quelconque des revendications précédentes, caractérisée en ce que dans un bloc moteur en aluminium une ou plusieurs surfaces de coulissement cylindriques d'un diamètre intérieur de 30 à 150 mm sont juxtaposées à une distance de 2 à 8 mm.

**14.** Pièce de fonderie en aluminium selon l'une quelconque des revendications précédentes, caractérisée en ce que l'épaisseur de la couche varie dans une plage de ± 10 % sur la longueur de la surface de coulissement intérieure, vue en direction de coulissement, et en ce que l'épaisseur de la couche présente une plage de tolérance de ± 10 %, vue sur la périphérie.

**15.** Procédé pour fabriquer des pièces de fonderie en aluminium à surface de coulissement intérieure cylindrique rodée selon l'une quelconque des revendications précédentes, dans lequel on nettoie tout d'abord la surface de la pièce de fonderie en aluminium, et ensuite on dépose une couche en substance dure, caractérisé en ce que l'on nettoie par un procédé d'attaque ionique la surface de la pièce de fonderie en aluminium sur la surface à revêtir présentant un profil de profondeur de rugosité de l'ordre de :

$$R_k = 0,5 - 3,0 \ \mu m$$

$$R_{nk} = 0,1 - 2,0 \ \mu m$$

$$R_{vk} = 0,5 - 5,0 \ \mu m$$

mesurée selon la norme DIN 4776, et en ce qu'immédiatement à la suite on dépose sur la structure de surface obtenue à partir de la phase gazeuse une couche en substance dure par un procédé de revêtement reproduisant la surface à des températures inférieures à 250°C, et en ce que l'on forme une couche de surface avec une proportion en substance dure supérieure à 80 atomes %.

**16.** Procédé selon la revendication précédente, caractérisé en ce que l'on applique en tant que procédé de revêtement reproduisant la surface un procédé PVD (plasma-vaccum-deposition/déposition par plasma sous vide), et en ce que la surface revêtue présente un profil de profondeur de rugosité de :

$$R_k = 0,5 - 2,8 \ \mu m$$

$$R_{nk} = 0,1 - 1,8 \ \mu m$$

$$R_{vk} = 0,5 - 4,8 \ \mu m.$$

**17.** Procédé selon l'une des revendications précédentes, caractérisé en ce que l'on dépose une couche multicouches, en ce que l'on vaporise tout d'abord une couche adhésive métallique en TiAl de la composition (50/50) sur le matériau de substrat, et en ce que l'on dépose sur ladite couche une couche de couverture en un métalloïde.

**18.** Procédé selon l'une quelconque des revendications précédentes, caractérisé en ce que l'on contrôle la composition de la couche adhésive par l'intermédiaire de la proportion en gaz réactif.

**14**

**19.** Procédé selon l'une quelconque des revendications précédentes, caractérisé en ce que la couche adhésive est constituée en TiAl de la composition (50/50), et en ce que l'on amène à réagir la couche de couverture en Ti, Si, Al et/ou Cr avec un gaz formant une phase dure (à métalloïde) parmi le groupe B, C, N, O à des températures de 150 à 250°C, et on ce qu'on la dépose sur la couche adhésive.

**20.** Procédé selon l'une quelconque des revendications précédentes, caractérisé en ce que l'on pose et on presse le couvercle du récepteur sous forme d'un couvercle de culasse sur les parois du récipient, et en ce que l'on contrôle la composition de la couche adhésive et de la couche de couverture par l'intermédiaire des proportions en gaz réactif.

**21.** Procédé selon l'une quelconque des revendications précédentes, caractérisé en ce que l'on pose le couvercle du récepteur uniquement sur les parois du récepteur (4 et 6) formant la périphérie extérieure.

**22.** Application d'un dispositif pour le revêtement par procédé PVD, constitué par un récipient comportant des éléments de cathode et d'anode ainsi que par des raccords de gaz et de vide, l'élément de cathode étant mobile et rétractable par rapport au récepteur pour un revêtement par procédé PVD d'une surface de coulissement intérieure cylindrique de pièces de fonderie en aluminium (3), la pièce de fonderie en aluminium (3) étant le récepteur pour l'opération de déposition.

**23.** Application d'un dispositif selon la revendication 22, caractérisée en ce que l'élément de cathode est réalisé sous forme de cathode en barre (1) qui est agencée en déplacement en direction longitudinale de la barre dans un couvercle (2a) du récepteur, en ce qu'un fond (2b) du récepteur présentant des raccords de gaz et de vide est agencé en vis-à-vis des cathodes en barre (1), et en ce que les surfaces de coulissement intérieures à revêtir sont réalisées sous forme de parois (4 à 8) du récepteur, le couvercle (2a) du récepteur et le fond (2b) du récepteur pouvant être refermés de façon étanche au vide avec les parois du récepteur.

**24.** Application d'un dispositif selon l'une ou l'autre des revendications 22 et 23, caractérisée en ce que des plaques d'obturation à surfaces d'étanchéité sont posées en tant qu'éléments d'obturation sur des contre-surfaces correspondantes d'un ou de plusieurs récepteurs, dont résulte(nt) une ou plusieurs chambres sous vide.

**25.** Application d'un dispositif selon l'une quelconque des revendications 22, 23, 24, caractérisée en ce que le fond (2a) du récepteur est formé par plusieurs surfaces individuelles (9 à 12) susceptibles d'être introduites chacune dans une pièce de fonderie en aluminium cylindrique (3) et d'être pressées de façon étanche au vide contre les surfaces de coulissement intérieures.

**26.** Application d'un dispositif selon l'une quelconque des revendications 22 à 25, caractérisée en ce que la contre-surface du récepteur est réalisée sous forme de surface d'étanchéité oeuvrée par voie mécanique.

**27.** Application d'un dispositif selon l'une quelconque des revendications 22 à 26, caractérisée en ce que l'on utilise une pièce d'étanchéité en un matériau résistant à la température.

**28.** Application d'un dispositif selon l'une quelconque des revendications 22 à 27, caractérisée en ce que l'on prévoit un ou plusieurs dispositifs de serrage pour poser les plaques d'obturation ainsi que pour refermer les chambres sous vide.

## Fig. 1

## Fig. 2

Fig. 3

Fig. 4

17

Fig. 5

Fig. 6